# EUROPÄISCHE PATENTANMELDUNG

(11) **EP 0 737 865 A2**
(43) Veröffentlichungstag der Anmeldung: **16.10.1996**
(21) Anmeldenummer: 96104450.0
(22) Anmeldetag: 20.03.1996
(51) Int. Cl.: G01R 25/08

(54) **Schaltungsanordnung zur digitalen Phasendifferenzmessung**

(30) Priorität: 11.04.1995 DE 19513795
(71) Anmelder: SIEMENS AKTIENGESELLSCHAFT, 80333 München (DE)
(72) Erfinder: Kramer, Ronalf, Dipl.-Ing., 81247 München (DE)

(57) **Zusammenfassung**

Schaltungsanordnung zum Messen der Phasendifferenz zwischen einem Ist-Signal (I) und einem Referenzsignals (R) mit einem Differenzierer (14), an den das Referenzsignal (R) angelegt ist und der ein differenziertes Referenzsignal (dR) abgibt,
mit einem digitalen Phasendetektor (15), dem das Ist-Signal (I) und das differenzierte Referenzsignal (dR) zugeführt werden und der ein der Phasendifferenz zwischen Ist-Signal (I) und differenziertem Referenzsignal (dR) entsprechendes erstes Binärsignal (B1) abgibt,
mit einer mehrere hintereinander geschaltete Laufzeitglieder (1) aufweisenden Laufzeitkette (13), in die das Referenzsignal (R) läuft und an die das differenzierte Referenzsignal (dR) angelegt ist, wobei bei Auftreten eines bestimmten logischen Zustandes des differenzierten Referenzsignals (dR) der erreichte logische Zustand der Laufzeitkette (13) festgehalten wird,
mit einer Auswerteeinrichtung (12), die mit der Laufzeitkette (13) verbunden ist, an die das differenzierte Referenzsignal (dR) angelegt ist und die aus dem festgehaltenen Zustand der Laufzeitkette (13) ein zweites Binärwort (B2) herleitet, und mit einer Verknüpfungseinrichtung (17), der erstes und zweites Binärwort (B1, B2) zugeführt werden und die daraus ein der Phasendifferenz zwischen Ist-Signal (I) und Referenzsignal (R) entsprechendes Ausgangsbinärwort (D) bildet.

## Beschreibung

Die Erfindung betrifft eine Schaltungsanordnung zur digitalen Messung der Phasendifferenz zwischen einem Ist-Signal und einem Referenzsignal.

Schaltungsanordnungen zur digitalen Phasendifferenzmessung - auch digitale Phasendetektoren genannt- sind in vielfältigen Ausführungsformen bekannt. Eine Ausführungsform ist beispielsweise bei U. Tietze, Ch. Schenk, Electronic Circuits-Design and Applications, Berlin und Heidelberg 1991, Seite 869f beschrieben. Derartige Schaltungsanordnungen vergleichen im allgemeinen ein Referenzsignal und ein Ist-Signal miteinander und erzeugen ein der Phasendifferenz beider Signale entsprechendes Binärwort. Der Vorteil von Schaltungssanordnungen zur digitalen Phasendifferenzmessung liegt in dem relativ geringen schaltungstechnischen Aufwand. Jedoch ist die Phasenauflösung nicht höher als die Periodendauer des höherfrequenteren der beiden Signale.

Andererseits ist aus der europäischen Patentschrift 0 463 206 ein Verfahren und eine Schaltungsanordnung zum Messen kleiner Phasendifferenzen bekannt, bei denen der Ist-Impuls in eine aus einer Vielzahl von Laufzeitgliedern bestehende Laufzeitkette läuft, der Ist-Impuls nach Maßgabe eines Steuersignals in der Laufzeitkette festgehalten wird, die Lage des Ist-Impulses in der Laufzeitkette durch taktgesteuertes Herausschieben ermittelt wird und die Anzahl der dabei noch zu durchlaufenden Laufzeitglieder die Phasendifferenz bestimmt. Der Vorteil einer derartigen Schaltungsanordnung besteht darin, daß auch sehr kleine Phasendifferenzen, die nur einen Bruchteil der Periodendauer des Referenzsignals betragen, gemessen werden können. Nachteilig ist allerdings, daß ein hoher schaltungstechnischer Aufwand zur Verlängerung der Laufzeitkette erforderlich ist, wenn der Meßbereich sich über mehrere Perioden des Referenzsignals erstrecken soll.

Der Erfindung liegt die Aufgabe zugrunde, eine Schaltungsanordnung der eingangs genannten Art bereitzustellen, die bei geringem schaltungstechnischen Aufwand über einen großen Meßbereich hinweg eine hohe Phasenauflosung aufweist.

Die Aufgabe wird durch eine Schaltungsanordnung gemaß Patentanspruch 1 gelöst. Ausgestaltungen und Weiterbildungen des Erfindungsgedankens sind Gegenstand von Unteransprüchen.

Die erfindungsgemäße Lösung beruht darauf, daß ein digitaler Phasenkomparator mit einer Schaltungsanordnung zum Messen kleiner Phasendifferenzen kombiniert wird, wobei durch eine spezielle Signalführung und unter Verwendung eines Differenzierers erreicht wird, daß durch den digitalen Phasenkomparator eine grobe Phasenmessung über mehrere Perioden des Referenzsignals erfolgt, während mit der die analoge Laufzeitkette enthaltenden Schaltungsanordnung eine Feinmessung über etwa eine Periodendauer des Referenzsignals erfolgt. Das Steuersignal für die Laufzeitkette wird dabei mittels des zusätzlichen Differenzierers aus dem Referenzimpuls abgeleitet, wobei der Meßbereich der Laufzeitkette adaptiv mitverschoben wird, wenn die Phasendifferenz mehr als eine Periode beträgt.

Die Erfindung wird nachfolgend anhand der in den Figuren der Zeichnung dargestellten Ausführungsbeispiele näher erläutert.
Es zeigt:
- Figur 1: ein Ausführungsbeispiel einer erfindungsgemäßen Schaltungsanordnung in einem Blockschaltbild,
- Figur 2: die logischen Zustände der Laufzeitkette für zwei gegeneinander phasenverschobene Referenzsignale in einem Diagramm,
- Figur 3: das Zusammenwirken von digitalem Phasendetektor und der Laufzeitkette in einem Diagramm und
- Figur 4: eine bevorzugte Ausgestaltung der Laufzeitkette sowie der zugehörigen Steuer- und Auswerteeinrichtungen in einem Diagramm.

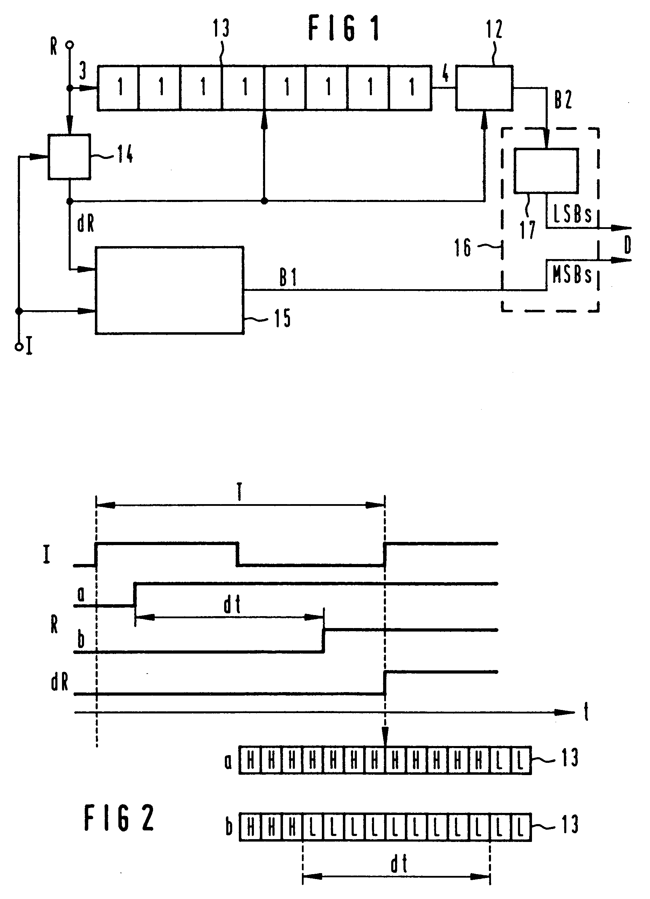

Bei dem Ausführungsbeispiel nach Figur 1 wird ein Ist-Signal I einem digitalen Phasendetektor 15 der beispielsweise eingangs genannten Art zugeführt, an dem darüber hinaus ein differenziertes Referenzsignal dR angelegt ist. Das differenzierte Referenzsignal dR wird durch einen Differenzierer 14 erzeugt, an den eingangsseitig ein Referenzsignal R angelegt ist. Zudem wird der Differenzierer 14 durch das Ist-Signal I getaktet. Ein derartiger Differenzierer 14 besteht beispielsweise aus einem UND-Gatter mit drei Eingängen, an dessen einen Eingang das Referenzsignal R direkt angelegt ist, dessen zweitem Eingang das Referenzsignal R unter Zwischenschaltung eines Verzögerungsgliedes zugeführt wird und dessen dritter Eingang durch das Ist-Signal I angesteuert wird.

Das Referenzsignal R wird weiterhin in eine Laufzeitkette 13 eingespeist, die mittels des differenzierten Referenzsignals dR gesteuert wird. Die Steuerung erfolgt dabei derart, daß das Referenzsignal R zunächst in die Laufzeitkette 13 läuft und bei Auftreten eines entsprechenden differenzierten Referenzsignals dR der augenblickliche logische Zustand der Laufzeitkette 13 "eingefroren" wird. Das "Einfrieren" kann auf verschiedene Weise erfolgen, wobei grundsätzlich zwischen zwei Arten unterschieden werden kann. Zum einen kann bei Auftreten des differenzierten Referenzsignals dR der aktuelle logische Zustand der Laufzeitkette in einen Speicher übernommen werden und das Referenzsignal R durchläuft die Laufzeitkette 13. Zum anderen besteht die Möglichkeit, den Signallauf in der Laufzeitkette 13 anzuhalten und die Laufzeitkette 13 selbst als Speicher zu nutzen. In beiden grundsätzlichen Fällen wird der "eingefrorene" logische Zustand einer Auswertung durch die Auswerteeinrichtung 12 zugrundegelegt.

Die Auswerteeinrichtung 12 ermittelt, wie weit das Referenzsignal R in der Laufzeitkette 13 zum Einfrierzeitpunkt vorangekommen ist. Die Auswertung kann auf verschiedene Weise erfolgen, wobei grundsätzlich eine parallele oder serielle Abfrage einzelner Laufzeitglieder 1 der Laufzeitkette 13 für den Einfrierzeitpunkt erfolgen kann.

Am Ausgang der Auswerteschaltung 12 steht ein Binärwort B2 zur Verfügung, das ebenso wie ein am Ausgang des digitalen Phasendetektors 15 bereitstehendes Binärwort B1 einer Verknüpfungseinrichtung 16 zugeführt wird. Diese besteht im einfachsten Fall lediglich aus einer Zusammenführung beider Binärwörter B1 und B2. Dabei bildet das Binärwort B1 die höherwertigen Stellen MSBs und das Binärwort B2 die niederwertigeren Stellen LSBs eines Ausgangsbinärwortes D. Das Ausgangsbinärwort D gibt in binärer Form die Phasendifferenz zwischen dem Differenzsignal R und dem Ist-Signal I wieder. Die Erfindung ausgestaltend enthält die Verknüpfungseinrichtung 16 eine Skalierungseinheit 17 zur Anpassung des Binärwortes B2 an das Binärwort B1. Eine Skalierungseinrichtung 17 ist insbesondere dann erforderlich, wenn die Laufzeit der Laufzeitkette 13 nicht exakt einer Periode des Referenzsignals R entspricht. Bevorzugt wird die Laufzeit der Laufzeitkette 13 gleich der Periode des Ist-Signals I gewählt.

Der Verlauf des Ist-Signals I und des Referenzsignals R bei verschiedenen Phasenlagen (a', b') sowie des daraus resultierenden differenzierten Referenzsignals dR über der Zeit t zeigt Figur 2. Das Ist-Signal I weist dabei eine Periodendauer T auf, die mit einer bestimmten Zustandsänderung - beispielsweise von L auf H- beginnt und mit der darauffolgenden, entsprechenden Zustandsänderung endet. Eine gewisse Zeitspanne nach der ersten Zustandsänderung des Ist-Signals I ändert auch das Referenzsignal R im Fall a) seinen Zustand, während Referenzsignal R im Fall b) demgegenüber um die Zeitspanne dt später seinen Zustand ändert. In beiden Fällen a) und b) liegen die Zustandsänderungen innerhalb der durch das Ist-Signal I vorgegebenen Periodendauer T. Durch die Zustandsänderung des Referenzsignals R wird eine Zustandsänderung des differenzierten Referenzsignals dR ausgelöst, die aufgrund der Taktung des Differenzierers 14 mit dem Ist-Signal I mit der zweiten Zustandsänderung des Ist-Signals I eintritt. Zu diesem Zeitpunkt wird der logische Zustand der Laufzeitkette 13 "eingefroren". Besteht die Laufzeitkette 13 beispielsweise aus 14 Laufzeitgliedern mit insgesamt einer Laufzeit von T, so führen die ersten 12 Laufzeitglieder den einen logischen Zustand -beispielsweise H- und die letzten beiden Laufzeitglieder den anderen Zustand L. Im Fall b) führen dementsprechend die ersten drei Laufzeitglieder den logischen Zustand H und die verbleibenden 11 Laufzeitglieder den logischen Zustand L. Zwischen den Änderungen des Zustands von H nach L in den Fällen a) und b) liegen demnach 9 Laufzeirglieder, die der Zeitspanne dt entsprechen. Die Zustandsänderungen in den Fällen a) und b) wären also Binärzahlen zuzuordnen, die beispielsweise einer 12 und einer 3 entsprechen. Die Zahlen ergeben sich jeweils aus der Anzahl der den Zustand H führenden Laufzeitgliedern. Insgesamt ergibt sich damit für die Anordnung bestehend aus der Laufzeitkette 13 und der Auswerteschaltung 12 eine Detektionskennlinie, die jeweils innerhalb einer Periodendauer T einen linearen Anstieg aufweist.

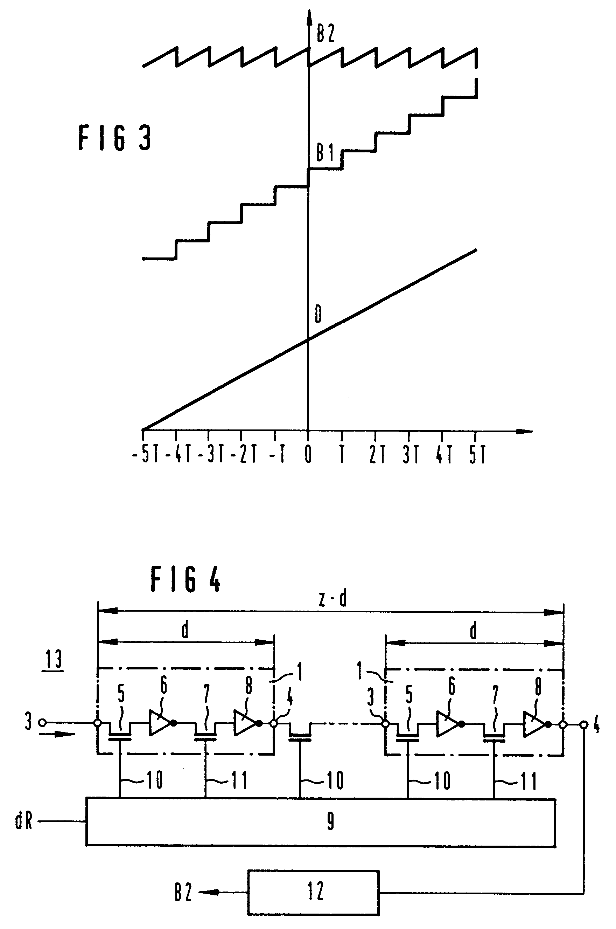

Gemäß Figur 3 ergibt sich demnach für das Binärwort B2 für den Detektionsbereich von beispielsweise -5 T bis 5 T ein sägezahnförmiger Verlauf mit der Periode T. Für das Binärwort B1 ergibt sich dagegen für den Bereich von -5 T bis 5 T ein treppenförmiger Verlauf mit einer Stufenbreite von T. Die Stufung ergibt sich aus der minimalen Auflösung des digitalen Phasendetektors 15, die gleich der Periodendauer T des Ist-Signals I ist. Durch Zusammensetzen der Binärworte B1 und B2 zum Ausgangsbinärwort D ergibt sich ein linear ansteigender Verlauf zwischen -5 T und 5 T. Die einzelnen "Zähne" des Sägezahnverlaufs des Binärwortes B2 werden dabei jeweils auf eine Stufe des Verlaufs des Binärwortes B1 gesetzt. Dies ergibt sich aus der Verschiebung des Meßbereichs der Anordnung mit Laufzeitkette 13 und Auswerteeinrichtung 12 an den aktuellen Arbeitspunkt des digitalen Phasendetektors 15. Somit ergibt sich ein gleichbleibend weiter Detektionsbereich mit einer gegenüber dem digitalen Phasendetektor 15 alleine erhöhten Auflösung.

Eine Weiterbildung der Laufzeitkette 13 ist in Figur 4 dargestellt. Im einzelnen zeigt Figur 4 eine Laufzeitkette 13 mit z hintereinander geschalteten Laufzeitgliedern 1 mit je einer Laufzeit d. Die Gesamtlaufzeit der Laufzeitkette ist damit z.d. Zwischen jede Eingangsklemme 3 und Ausgangsklemme 4 jedes Laufzeitgliedes 1 ist die Reihenschaltung einer Laststrecke einer ersten Transistors 5, eines ersten Inverters 6, einer Laststrecke eines zweiten Transistors 7 sowie eines zweitern Inverters 8 angeordnet, wobei die Steueranschlüsse der ersten und zweiten Transistoren 5, 7 mit einer durch durch das differenzierte Referenzsignal dR angesteuerten Steuereinrichtung 9 verbunden sind.

An die Ausgangsklemme 4 des letzten Laufzeitgliedes 1 ist die digitale Auswerteschaltung 12 geschaltet, an der das Binärwort B2 abgreifbar ist. Die Steuereinrichtung 9 ist so ausgebildet, daß sie einerseits die ersten und zweiten Transistoren 5 und 7 gemeinsam einschalten und andererseits die ersten und zweiten Transistoren 5, 7 abwechselnd einschalten kann, so daß ein in den Laufzeitgliedern 1 gespeicherter Impuls nach Art eines Schieberegisters aus der Laufzeitkette 13 herausgeschoben werden kann.

Dabei wird das Referenzsignal R zunächst an die Eingangsklemme 3 des ersten Laufzeitgliedes 1 gelegt, wobei sämtliche Transistoren 5 und 7 durch die Steuereinrichtung 9 eingeschaltet sind. Damit läuft das Referenzsignal R in die Laufzeitkette 13 so lange hinein, bis nach Maßgabe eines Steuersignals das Referenzsignal R in der Laufzeitkette 13 festgehalten wird. Das Steuersignal wird dabei von der Steuereinrichtung 9 geliefert. Anschließend wird die Lage des Referenzsignals R in der Laufzeitkette 13 durch von der Steuereinrichtung 9 taktgesteuertes Herausschieben ermittelt. Die Anzahl der dabei noch zu durchlaufenden Laufzeitglieder 1 bestimmt das Binärwort B2, die von der Auswerteschaltung 12 erfaßt wird. Das so ermittelte Binärwort B2 ist also mit der Genauigkeit der Laufzeit d eines Laufzeitgliedes 1 aufgelöst. Dabei wird das Produkt z.d in etwa gleich der Periodendauer T des Ist-Signals I gewählt.

## Patentansprüche

1. Schaltungsanordnung zum Messen der Phasendifferenz zwischen einem Ist-Signal (I) und einem Referenzsignals (R) mit einem Differenzierer (14), an den das Referenzsignal (R) angelegt ist und der ein differenziertes Referenzsignal (dR) abgibt,
mit einem digitalen Phasendetektor (15), dem das Ist-Signal (I) und das differenzierte Referenzsignal (dR) zugeführt werden und der ein der Phasendifferenz zwischen Ist-Signal (I) und differenziertem Referenzsignal (dR) entsprechendes erstes Binärsignal (B1) abgibt,
mit einer mehrere hintereinander geschaltete Laufzeitglieder (1) aufweisenden Laufzeitkette (13), in die das Referenzsignal (R) läuft und an die das differenzierte Referenzsignal (dR) angelegt ist, wobei bei Auftreten eines bestimmten logischen Zustandes des differenzierten Referenzsignals (dR) der erreichte logische Zustand der Laufzeitkette (13) festgehalten wird,
mit einer Auswerteeinrichtung (12), die mit der Laufzeitkette (13) verbunden ist, an die das differenzierte Referenzsignal (dR) angelegt ist und die aus dem festgehaltenen Zustand der Laufzeitkette (13) ein zweites Binärwort (B2) herleitet, und mit einer Verknüpfungseinrichtung (17), der erstes und zweites Binärwort (B1, B2) zugeführt werden und die daraus ein der Phasendifferenz zwischen Ist-Signal (I) und Referenzsignal (R) entsprechendes Ausgangsbinärwort (D) bildet.

2. Schaltungsanordnung nach Anspruch 1,
**dadurch gekennzeichnet,** daß der Differenzierer (14) durch das Ist-Signal (I) getaktet wird.

3. Schaltungsanordnung nach Anspruch 1 oder 2,
**dadurch gekennzeichnet,** daß die Verknüpfungseinrichtung (17) eine Skalierungseinrichtung (16) enthält, die das zweite Binärwort (B2) an das erste Binärwort (B1) anpaßt.

4. Schaltungsanordnung nach einem der Ansprüche 1 bis 3, **dadurch gekennzeichnet,** daß die Laufzeitkette (13) derart ausgebildet ist, daß sie eine Laufzeitverzögerung von einer Taktperiode des Referenzsignals (R) erzeugt.

5. Schaltungsanordnung nach einem der Ansprüche 1 bis 4, **dadurch gekennzeichnet,** daß die Auswerteschaltung (12) beim festgehaltenen logischen Zustand der Laufzeitkette (13) den Übergang des logischen Zustandes zwischen zwei Laufzeitgliedern (1) ermittelt und anhand der Position dieser beiden Laufzeitglieder (1) innerhalb der Laufzeitkette (13) das zweite Binärwort (B2) herleitet.

6. Schaltungsanordnung nach einem der Ansprüche 1 bis 5, **dadurch gekennzeichnet,** daß jedes Laufzeitglied (1) jeweils eine zwischen seinen Eingang und seinen Ausgang angeordnete Reihenschaltung der Laststrecke eines ersten Transistors (5), eines ersten Inverters (6), der Laststrecke eines zweiten Transistors (7) sowie eines zweiten Inverters (8) aufweist,
daß der Ausgang der Laufzeitkette (13) mit der Auswerteschaltung (12) verbunden ist und
daß eine Steuerschaltung, an die das differenzierte Referenzsignal (dR) angelegt ist, mit den Steueranschlüssen der ersten und zweiten Transistoren (5, 7) verbunden ist.

7. Schaltungsanordnung nach Anspruch 6,
**dadurch gekennzeichnet,** daß zum Einlaufen des Referenzsignals (R) in die Laufzeitkette (13) alle ersten und zweiten Transistoren (5, 7) durch die Steuereinrichtung (9) gemeinsam durchgeschaltet sind und zum Herausschieben des Referenzsignals (R) abwechselnd eingeschaltet sind.
